# EUROPÄISCHE PATENTANMELDUNG

(11) **EP 4 376 065 A1**
(43) Veröffentlichungstag der Anmeldung: **29.05.2024**
(21) Anmeldenummer: 23211468.6
(22) Anmeldetag: 22.11.2023
(51) Int. Cl.: H01L 21/78, H01L 33/00

(54) **VERFAHREN ZUR HERSTELLUNG MIKROELEKTRONISCHER KOMPONENTEN**

(30) Priorität: 28.11.2022 DE 102022212677
(71) Anmelder: 3D-Micromac AG, 09126 Chemnitz (DE)
(72) Erfinder: Leichsenring, Torsten, 08134 Wildenfels (DE); Li, Qingfeng, 09130 Chemnitz (DE); Clair, Maurice, 09125 Chemnitz (DE)
(74) Vertreter: Patentanwälte Ruff, Wilhelm, Beier, Dauster & Partner mbB

(57) **Zusammenfassung**

Die Erfindung betrifft ein Verfahren zur Herstellung mikroelektronischer Komponenten, die einen Träger (140) und ein auf dem Träger (140) aufgebrachtes mikroelektronisches Funktionsschichtsystem (130) aufweisen, mit folgenden Schritten: a) Bilden eines Funktionsschichtsystems (130) auf einer Vorderseite (112) eines Aufwachssubstrats (110); b) Aufbringen eines schichtförmigen Trägers (140) auf das Funktionsschichtsystem (130) zur Bildung eines Werkstücks (100) in Form eines Schichtverbunds, der den Träger (140), das Funktionsschichtsystem (130) und das Aufwachssubstrat (110) aufweist; c) Befestigen des Werkstücks (100) auf einem Werkstückträger derart, dass eine der Vorderseite (112) gegenüberliegende Rückseite (114) des Aufwachssubstrats (110) zugänglich ist; d) Erzeugen einer für einen Laserstrahl (650) transparenten Glättungsschicht (330) an der Rückseite (114) des Aufwachssubstrats (110); e) Einstrahlen des Laserstrahls (650) von der Rückseite (114) des Aufwachssubstrats (110) durch die Glättungsschicht (330) und durch das Aufwachssubstrat (110) hindurch derart, dass der Laserstrahl (650) in einem Grenzbereich zwischen dem Aufwachssubstrat (110) und dem Funktionsschichtsystem (130) fokussiert wird und eine Verbindung zwischen dem Aufwachssubstrat (110) und dem Funktionsschichtsystem (130) im Grenzbereich geschwächt oder zerstört wird; f) Trennen eines den Träger (140) und das Funktionsschichtsystem (130) aufweisenden Funktions-Schichtstapels (150) von dem Aufwachssubstrat (110); wobei die Glättungsschicht (330) derart erzeugt wird, dass zum Ende des Schritts d) die Glättungsschicht (330) mit fester Struktur vorliegt.

## Beschreibung

### ANWENDUNGSGEBIET UND STAND DER TECHNIK

Die Erfindung betrifft ein Verfahren zur Herstellung mikroelektronischer Komponenten gemäß dem Oberbegriff von Anspruch 1. Die Erfindung betrifft zudem eine Aufwachssubstratanordnung gemäß dem Oberbegriff von Anspruch 22.

Bei der Herstellung von mikroelektronischen Komponenten, wie z.B. optoelektronischen Bauelementen, besteht oft die Aufgabe, einen aus einer Vielzahl von Schichten bestehenden Schichtstapel zwischen zwei definierten Schichten aufzutrennen, um so zwei einzelne Schichtstapel zu erhalten. Beispielsweise werden Lichtemittierende Dioden (LEDs) heutzutage häufig hergestellt, indem auf einem als Aufwachssubstrat dienenden Saphirwafer durch epitaktisches Wachstum p- und n-dotierte Halbleiterschichten aus Galliumnitrid (GaN) gebildet werden. Diese Schichten haben jeweils eine Dicke von wenigen µm, die Gesamtdicke der verschiedenen GaN-Schichten kann z.B. weniger als 10 µm betragen. Vor der weiteren Bearbeitung kann eine Strukturierung der GaN-Schichten, beispielsweise durch Laserbearbeitung, erfolgen, um einzelne Bauelemente herzustellen oder deren Herstellung vorzubereiten. Auf den GaN-Schichtstapel wird eine dünne, in der Regel metallische Verbindungsschicht beispielsweise durch Aufdampfen aufgebracht. Mit Hilfe dieser Verbindungsschicht wird das Aufwachssubstrat mit dem darauf befindlichem GaN-Schichtstapel mit einem schichtförmig flachen Träger verbunden. Später wird die flächige Verbindung zwischen dem Aufwachssubstrat und dem GaN-Stapel gelöst. Dadurch wird der GaN-Stapel auf den Träger transferiert. Der Träger mit dem davon getragenen GaN-Stapel dient als Basis zur Herstellung der mikroelektronischen Komponente.

Das Trennen des den Träger und den GaN-Schichtstapel aufweisenden Funktions-Schichtstapels vom Aufwachssubstrat erfolgt heutzutage meist mithilfe des sogenannten Laser-Lift-Off-Verfahrens (LLO). Dabei wird eine Pufferschicht, die sich im Grenzbereich zwischen dem Aufwachssubstrat und den GaN-Schichten befindet, durch Laserbestrahlung zerstört oder entfernt. Die Bestrahlung erfolgt dabei von der Rückseite des Aufwachssubstrats her und durch dieses hindurch, wobei der Laserstrahl auf die Pufferschicht bzw. den Grenzbereich fokussiert ist. Anschließend kann das Aufwachssubstrat durch externe Krafteinwirkung von den anderen Schichten getrennt werden.

Ein derartiges Verfahren ist z.B. in dem Artikel "Laser-Lift-Off: Geringere Bauhöhen in der Mikroelektronik durch Substrat-Transfer" von R. Delmdahl in: Photonik 2, 2013, Seiten 54 bis 56 beschrieben.

Aus der DE 10 2017 205 635 A1 ist vor diesem Hintergrund ein gattungsgemäßes Verfahren bekannt. Dieses sieht vor, dass vor Bearbeitung durch Laserbestrahlung eine Flüssigkeit auf eine Rückseite des Aufwachssubstrats in Form einer flüssigen Immersionsschicht aufgebracht wird. Durch diese Immersionsschicht und das Aufwachssubstrat hindurch wird bei dem bekannten Verfahren dann ein Laserstrahl in einem Grenzbereich zwischen Aufwachssubstrat und Funktionsschichtsystem fokussiert. Infolge der Fokussierung des Laserstrahls im Grenzbereich wird eine Verbindung zwischen Aufwachssubstrat und Funktionsschichtsystem geschwächt, so dass ein Funktions-Schichtstapel mit dem Funktionsschichtsystem und mit dem Träger von dem Aufwachssubstrat getrennt werden kann. Im Anschluss wird die flüssige Immersionsschicht von dem Aufwachssubstrat entfernt.

Nach den Beobachtungen der Erfinder können Bestandteile der Immersionsflüssigkeit, wie z. B. Kohlenwasserstoffe, während der Laserbearbeitung ausgasen, weshalb die Kompatibilität mit Prozessen und Anlagen der Mikroelektronikfertigung unter Umständen nicht gegeben ist.

### AUFGABE UND LÖSUNG

Vor diesem Hintergrund liegt der Erfindung die Aufgabe zugrunde, ein Verfahren der gattungsgemäßen Art so auszugestalten, dass der Trennschritt, mit dem das als temporäres Substrat dienende Aufwachssubstrat von dem Funktionsschichtsystem getrennt wird, zuverlässiger als bisher ausführbar ist. Zudem soll die Effizienz des Verfahrens im Vergleich zum Stand der Technik verbessert werden.

Zur Lösung dieser Aufgabe stellt die Erfindung ein Verfahren mit den Merkmalen von Anspruch 1 und eine Aufwachssubstratanordnung mit den Merkmalen von Anspruch 22 bereit. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Das Verfahren dient zur Herstellung mikroelektronischer Komponenten, die einen Träger und ein auf dem Träger aufgebrachtes mikroelektronisches Funktionsschichtsystem aufweisen. Das Verfahren weist einen Schritt a) auf. Gemäß dem Schritt a) wird ein Funktionsschichtsystem auf einer Vorderseite eines Aufwachssubstrats gebildet. Das Verfahren weist außerdem einen Schritt b) auf. Gemäß dem Schritt b) wird ein schichtförmiger Träger auf das Funktionsschichtsystem zur Bildung eines Werkstücks in Form eines Schichtverbunds aufgebracht, der den Träger, das Funktionsschichtsystem und das Aufwachssubstrat in Form eines Schichtstapels aufweist. Gemäß einem Schritt c) wird dieses Werkstücks auf einem Werkstückträger derart befestigt, dass eine der Vorderseite gegenüberliegende Rückseite des Aufwachssubstrats für eine nachfolgende Laserbearbeitung zugänglich ist. Das Verfahren weist einen Schritt d) auf, der vorzugsweise zeitlich vor der Laserbearbeitung durchgeführt wird. Gemäß dem Schritt d) wird eine für einen Laserstrahl transparente Glättungsschicht an der Rückseite des Aufwachssubstrats erzeugt. Die Laserbearbeitung kann in einem Schritt e) des Verfahrens erfolgen. Der Schritt e) weist ein Einstrahlen (mindestens) eines Laserstrahls von der Rückseite des Aufwachssubstrats durch die Glättungsschicht und durch das Aufwachssubstrat hindurch auf. Dabei wird der Laserstrahl derart eingestrahlt, dass der Laserstrahl in einem Grenzbereich zwischen dem Aufwachssubstrat und dem Funktionsschichtsystem fokussiert und eine zunächst noch vorhandene Verbindung zwischen dem Aufwachssubstrat und dem Funktionsschichtsystem im Grenzbereich geschwächt oder zerstört wird. In einem Schritt f) wird ein Funktions-Schichtstapel, der den Träger und das darauf angebrachte Funktionsschichtsystem aufweist, von dem Aufwachssubstrat getrennt. Es findet also ein Substrat-Transfer des Funktionsschichtsystems von dem Aufwachssubstrat auf den Träger statt. Durch diese Vorgehensweise ist eine ökonomische Fertigung vor allem von Halbleiterstrukturen auf immer größeren und immer empfindlicheren Trägern möglich.

Gemäß der beanspruchten Erfindung wird die Glättungsschicht derart erzeugt, dass zum Ende des Schritts d) die Glättungsschicht mit fester Struktur vorliegt. Eine Glättungsschicht mit fester Struktur wird im Rahmen der vorliegenden Anmeldung synonym auch als "feste Glättungsstruktur" bezeichnet. "Mit fester Struktur" kann also "solide" und/oder "als Festkörper" bedeuten. Insbesondere liegt die feste Glättungsschicht zum Ende des Schritts d) in nichtflüssiger Phase vor. Ein Material der Glättungsschicht kann somit zum Ende des Schritts d) in festem Aggregatzustand vorliegen. Die feste Struktur liegt vor, wenn der Schritt d) abgeschlossen ist. Dies schließt insbesondere nicht aus, dass bei der Erzeugung der Glättungsschicht ein Rohmaterial zum Einsatz kommen kann, das zunächst nicht mit fester Struktur vorliegt. Allerdings gilt die Glättungsschicht zum Abschluss von Schritt d) erst dann als erzeugt, wenn ein Material der Glättungsschicht, das auf dem Rohmaterial basieren kann, eine feste Struktur aufweist. Mit anderen Worten: eine flüssige Immersionsschicht ist keine Glättungsschicht im Sinne der vorliegenden Erfindung. Der Begriff "feste Struktur" kann auch amorphe Strukturen, beispielsweise unterkühlter Flüssigkeiten wie Glas, umfassen.

Auf vorstehende Weise lässt sich vorteilhaft eine besonders haltbare Glättungsschicht erzeugen. Unter andrem kann die Glättungsschicht mit fester Struktur besonders temperaturbeständig sein. Die Glättungsschicht kann beispielsweise mitsamt dem Aufwachssubstrat wiederverwendbar sein, um für eine serielle Herstellung mikroelektronischer Komponenten mehrfach verwendet werden zu können. Das Aufwachssubstrat und die darauf haftende feste Glättungsschicht können eine Aufwachssubstratanordnung ausbilden. Diese kann als Zwischenprodukt des Verfahrens angesehen werden, aber auch als ein für sich genommen handhabbares, verkehrsfähiges Produkt, das bereits für die Laserbearbeitung vorbereitet ist.

Die Glättungsschicht dient vorteilhaft dazu, eine im Vergleich zur Rückseite des Aufwachssubstrats relativ glatte Oberfläche zur Einkopplung des Laserstrahls bei Durchführung von Schritt e) bereitzustellen, die Vorteile hinsichtlich von Streueffekten, einer Fokussierbarkeit sowie einer Strahlqualität des Laserstrahls bietet. Durch die Glättungsschicht kann eine Oberflächenrauheit der Rückseite des Aufwachssubstrats wenigstens teilweise ausgeglichen werden in dem Sinne, dass die Rauheit der freien Oberfläche der Glättungsschicht deutlich geringer sein kann als die Oberflächenrauheit der (unbeschichteten) Rückseite.

Bei zahlreichen im Rahmen der Erfindung möglichen Prozessvarianten können Aufwachssubstrate verwendet werden, die durch mechanische Trennprozesse von einem größeren Substratmaterialblock abgetrennt werden. Beispielsweise werden als Aufwachssubstrate verwendbare Saphirwafer heutzutage typischerweise mit einer Säge aus einem großen Saphir-Block geschnitten. Die dadurch erhältlichen Oberflächen können relativ rau sein. Wird eine solche raue Oberfläche mit einem Laser durchstrahlt, können Streueffekte zu einer Verschlechterung der Fokussierbarkeit und der Strahlqualität sowie zu einer Verringerung der für die Bearbeitung zur Verfügung stehenden Laserleistung führen. Es können infolge derartiger Streueffekte außerdem sogenannte Hot-Spots entstehen, die zu einer lokalen Zerstörung des Funktionsschichtsystems führen können, sowie Bereiche geringer Intensität, in denen keine oder nur in unzureichendem Ausmaß Bearbeitung stattfindet. Dem wird mittels der Glättungsschicht entgegengewirkt. Dabei ermöglicht es die Glättungsschicht, ein alternativ oder zusätzlich mögliches Glätten der als Einstrahlfläche dienenden Rückseite des Aufwachssubstrats mittels Polierens oder auf andere Weise einzusparen. Somit können also ein oder mehrere zusätzliche Bearbeitungsschritte am Aufwachssubstrat entfallen, wodurch der Gesamtprozess zeitsparender und kostengünstiger durchgeführt werden kann.

In Ausgestaltung der Erfindung werden beim Erzeugen der Glättungsschicht gemäß Schritt d) an der Rückseite des Aufwachssubstrats vorhandene Höhenunterschiede eines Rauheitsprofils mit einem Material der Glättungsschicht teilweise oder vollständig ausgeglichen. Vorteilhaft lassen sich somit diese Höhenunterschiede des Rauheitsprofils wenigstens teilweise ausgleichen, indem durch das Material der Glättungsschicht eine neue, insbesondere weniger raue, Oberfläche im Abstand zu der Rückseite des Aufwachssubstrats erzeugt wird.

Zweckmäßig werden zum wenigstens teilweisen Ausgleich der Höhenunterschiede des Rauheitsprofils Vertiefungen des Rauheitsprofils mit dem Material der Glättungsschicht wenigstens teilweise, insbesondere vollständig, aufgefüllt.

In weiterer Ausgestaltung der Erfindung wird zum Erzeugen der Glättungsschicht gemäß Schritt d) ein flüssiges Rohmaterial für die Glättungsschicht mit der Rückseite des Aufwachssubstrats in Kontakt gebracht und anschließend unter Ausbildung der Glättungsschicht ausgehärtet. Ein solches flüssiges Rohmaterial eignet sich besonders, um in Vertiefungen des an der Rückseite des Aufwachssubstrats vorhandenen Rauheitsprofils einzudringen. Auf diese Weise können insbesondere auch besonders feine Höhenunterschiede mit Rohmaterial ausgeglichen werden. Insbesondere können die Höhenunterschiede ausgeglichen werden, ohne dass Gas bzw. Luftblasen an Talsohlen von Vertiefungen des Rauheitsprofils verbleiben. Durch das Eindringen des Rohmaterials in die Vertiefungen können nach der Aushärtung Verkrallungseffekte erzielt werden, die zu einer besonders starken Haftung der Glättungsschicht an der Rückseite des Aufwachssubstrats führen.

Bei manchen Verfahrensvarianten kann das flüssige Rohmaterial durch einen Spin-Coating-Prozess aufgebracht werden, wodurch eine besonders zügige und gleichmäßige Beschichtung bzw. Benetzung mit dem flüssigen Rohmaterial mit ausreichender Dicke möglich ist. Die Flüssigkeit wird anschließend zur Erzeugung der Glättungsschicht ausgehärtet. Spin-Coating kann sich insbesondere anbieten, wenn als flüssiges Rohmaterial ein Lack, insbesondere ein Photoresist, verwendet wird. Es versteht sich, dass auch andere Prozesse zum Aufbringen des flüssigen Rohmaterials denkbar sind, beispielsweise Slot-Die-Coating, Spray-Coating oder Aerosol-Jet-Druck.

Zum Aushärten kann dem flüssigen Rohmaterial Energie in Form von Wärme oder Licht zugeführt werden. Beispielsweise kann das flüssige Rohmaterial zur Aushärtung mit Wärme, Laserstrahlung, UV-Licht oder Plasma bestrahlt werden.

In weiterer Ausgestaltung der Erfindung weist das flüssige Rohmaterial eine Viskosität von 1 mPas bis 3.000 mPas, insbesondere von 3 mPas bis 300 mPas, auf. Ein solches Rohmaterial lässt sich besonders gleichmäßig auf dem Aufwachssubstrat verteilen. Vorzugsweise sind das flüssige Rohmaterial und das Aufwachssubstrat hinsichtlich ihrer Oberflächenspannungen sowie einer Grenzflächenspannung zwischen dem Rohmaterial und der Rückseite des Aufwachssubstrats aufeinander abgestimmt, derart dass die Rückseite vollständig mit dem flüssigen Rohmaterial benetzt wird. Ein Spreitparameter kann größer null sein.

In weiterer Ausgestaltung der Erfindung weist das flüssige Rohmaterial wenigstens ein vernetzungsfähiges Polymer auf. Dabei weist ein Aushärten zur Glättungsschicht ein Vernetzen des Polymers auf. Bei dem Polymer kann es sich um ein Silikon oder um ein Polymethylmethacrylat (PMMA) oder um ein Polysilazan handeln. Das Polymer kann Bestandteil eines Photoresists sein. Vorteilhaft lässt sich durch die Verwendung eines vernetzungsfähigen Polymers eine besonders robuste, insbesondere schlagzähe, Glättungsschicht erzeugen. Vorteilhaft lässt sich mittels eines Polymers zudem eine besonders stark an der Rückseite haftende Glättungsschicht erzeugen.

Zweckmäßig kann bei Verwendung von Polysilazan für die Glättungsschicht eine Pyrolyse des an der Rückseite des Aufwachssubstrats angebrachten Polysilazans erfolgen. Infolge der Pyrolyse des Polysilazans kann ein keramisches Material der Glättungsschicht erzeugt werden. Eine derartige Glättungsschicht erweist sich als besonders widerstandsfähig gegenüber thermischer Beanspruchung und/oder aggressiven Medien. Zeitlich vor der Pyrolyse kann eine Trocknung erfolgen.

In weiterer Ausgestaltung der Erfindung umfasst das flüssige Rohmaterial eine Suspension oder eine kolloidale Dispersion mit wenigstens einem Glas-Rohstoff. Dabei wird das flüssige Rohmaterial zum Aushärten zunächst getrocknet und anschließend thermisch behandelt, um aus dem Glas-Rohstoff ein Glasmaterial der Glättungsschicht zu erzeugen. Eine derartige Glas-Glättungsschicht kann eine besonders glatte Oberfläche aufweisen.

In weiterer Ausgestaltung der Erfindung wird die Glättungsschicht bei Durchführung des Schritts d) mehrlagig erzeugt. Die mehrlagige Glättungsschicht wird dabei mit wenigstens zwei Schichtlagen der Glättungsschicht erzeugt. Entsprechend kann die Glättungsschicht zum Ende des Schritts d) mehrlagig vorliegen. Die vorstehend erläuterten Merkmale und die nachstehend noch zu erläuterten Merkmale der Glättungsschicht und ihrer Erzeugung können für die Glättungsschicht insgesamt sowie jeweils für jede ihrer Schichtlagen gelten. Die Schichtlagen können sich in ihrem Material sowie in ihrer Herstellung unterscheiden. Die mehreren Schichtlagen können also die vorstehend erläuterten und die nachstehend noch zu erläuterten Materialen und Herstellungsprozesse für die mehrlagige Glättungsschicht miteinander kombinieren. Wenn Aushärtschritte involviert sind, können die Materialien der Schichtlagen zeitgleich oder zeitlich nacheinander ausgehärtet werden.

In weiterer Ausgestaltung der Erfindung umfasst die Glättungsschicht eine Folie oder eine mit Klebstoff beschichtete Folie. Dabei wird die Folie zum Erzeugen der Glättungsschicht gemäß Schritt d) auf der Rückseite des Aufwachssubstrats derart befestigt, dass an der Rückseite des Aufwachssubstrats vorhandene Höhenunterschiede eines Rauheitsprofils von der Folie und/oder dem Klebstoff teilweise oder vollständig ausgeglichen werden. Vorteilhaft kann bei Verwendung einer derartigen Folie auf ein zeitaufwändiges Aushärten der Glättungsschicht verzichtet werden.

In weiterer Ausgestaltung der Erfindung bildet die Folie oder die mit Klebstoff beschichtete Folie die Glättungsschicht aus. Mit anderen Worten: Die Glättungsschicht besteht in diesem Fall aus der Folie (einlagige Glättungsschicht) oder einer mit Klebstoff beschichteten Folie (zweilagige Glättungsschicht). Alternativ wird die Folie oder die mit Klebstoff beschichtete Folie auf einer bereits an der Rückseite des Aufwachssubstrats angebrachten, d. h. weiteren, Schichtlage der Glättungsschicht angebracht. Bei Verwendung von aushärtbarem Material für die weitere Schichtlage kann dieses Material vor oder nach dem Anbringen der Folie oder der mit Klebstoff beschichteten Folie ausgehärtet werden.

In weiterer Ausgestaltung der Erfindung wird die Folie auf die Rückseite des Aufwachssubstrats aufgedrückt, insbesondere aufgewalzt. Dabei wird die Folie derart aufgedrückt, dass die Folie bzw. der zwischen Folie und Rückseite angeordnete Klebstoff in an der Rückseite des Aufwachssubstrats vorhandene Vertiefungen des Rauheitsprofils gedrückt wird. Alternativ oder zusätzlich wird infolge des Andrückens der Folie eine bereits - d. h. vor dem Anbringen der Folie - an der Rückseite des Aufwachssubstrats angebrachte Schichtlage der Glättungsschicht in die an der Rückseite vorhandenen Vertiefungen gedrückt. Dies fördert die vollständige Auffüllung von Vertiefungen des Rauheitsprofils der Rückseite, um die Höhenunterschiede auszugleichen. Zudem kann das Andrücken eine Haftung der Folie an der Rückseite des Aufwachssubstrats steigern.

In weiterer Ausgestaltung der Erfindung wird ein an der Rückseite des Aufwachssubstrats angebrachtes Rohmaterial der Glättungsschicht mittels einer Folie in an der Rückseite des Aufwachssubstrats vorhandene Vertiefungen des Rauheitsprofils gedrückt. Insbesondere kann das Rohmaterial dabei als Schichtlage der Glättungsschicht an der Rückseite angebracht sein, bevor es in die Vertiefungen gedrückt wird. Zum Drücken des Rohmaterials in die Vertiefungen kann die Folie auf das Rohmaterial aufgewalzt werden. Das in die Vertiefungen gedrückte Rohmaterial wird zur Erzeugung der Glättungsschicht ausgehärtet. Anschließend wird die Folie wieder entfernt. Bei dieser Ausgestaltung ist die Folie also kein Bestandteil der Glättungsschicht. Abgesehen von diesem Unterschied können die Folie in ihrer Art sowie die Anbringung der Folie der vorstehenden und der nachstehenden Beschreibung entsprechen. Dadurch, dass das Rohmaterial mittels der Folie in die Vertiefungen gedrückt wird, lässt sich eine Schichtdicke der Glättungsschicht im Wesentlichen auf lokale Maxima des Rauheitsprofils beschränken, wobei überschüssiges Rohmaterial seitlich aus einer Fuge zwischen Folie und Rückseite herausgedrückt werden kann. Nach Entfernung der Folie, sobald das Rohmaterial wenigstens teilweise oder vollständig ausgehärtet ist, kann die verbleibende Glättungsschicht eine besonders geringe Schichtdicke und somit eine besonders geringe Absorption für die Laserstrahlung aufweisen. Zweckmäßig kann eine Folie ausgewählt werden, die eine besonders geringe Haftung zur ausgehärteten Glättungsschicht aufweist, z.B. eine PTFE-Folie oder eine Folie, die an ihrer Kontaktfläche für die Glättungsschicht mit einem Trennmittel beschichtet ist. Im Falle der zu entfernenden Folie, kann die Folie opak ausgebildet sein, um einem versehentlichen Verbleiben der Folie auf der Glättungsschicht entgegenzuwirken.

In weiterer Ausgestaltung der Erfindung wird zum Erzeugen der Glättungsschicht gemäß Schritt d) ein Rohmaterial auf die Rückseite des Aufwachssubstrats mittels eines vakuumgestützten Prozesses aufgebracht. In einem solchen vakuumgestützten Prozess kann das Rohmaterial z.B. mittels physikalischer Gasphasenabschneidung (PVD-Prozess) oder chemischer Gasphasenabscheidung (CVD-Prozess) aufgebracht werden. Geeignete PVD-Prozesse sind z.B. Aufdampfen oder Sputtern. Im Anschluss an das Aufdampfen erstarrt das Rohmaterial unter Ausbildung der festen Glättungsschicht. Das Rohmaterial kann zweitweise in Form eines Gases vorliegen und infolge des Aufdampfens an der Rückseite des Aufwachssubstrats kondensieren oder resublimieren. Ein Vakuumbeschichten erlaubt die unmittelbare Erzeugung der Glättungsschicht mit fester Struktur, insbesondere in Form eines Festkörpers, ohne Notwendigkeit eines zusätzlichen Schritts zur Aushärtung. Mittels eines derartigen Vakuumbeschichtungsverfahrens kann ein nicht-flüssiges Rohmaterial aufgebracht werden.

Bei Erzeugung der Glättungsschicht mittels Sputterns kann als Material der Glättungsschicht z.B. auch Aluminiumoxid verwendet werden. Aluminiumoxid bietet besonders vorteilhafte optische Eigenschaften.

In weiterer Ausgestaltung der Erfindung weist das Verfahren einen zusätzlichen Schritt g) auf, der vorzugsweise zeitlich nach Schritt e) durchgeführt wird. Gemäß Schritt g) erfolgt ein Entfernen der Glättungsschicht von dem Aufwachssubstrat. Somit kann das Aufwachssubstrat nach der Herstellung der elektronischen Komponente mittels des Verfahrens in seinen Ausgangszustand zurückversetzt werden, um z. B. für eine erneute Durchführung des Verfahrens erneut verwendet werden zu können. Schritt g) wird insbesondere nur dann durchgeführt, wenn die Glättungsschicht vorbestimmte Qualitätsanforderungen für die Laserbearbeitung nicht mehr erfüllen kann.

In weiterer Ausgestaltung der Erfindung umfasst das Verfahren einen zusätzlichen Schritt c*), der zeitlich vor Schritt d) durchgeführt wird. Gemäß dem Schritt c*) erfolgt ein Bearbeiten der Rückseite zur Erzeugung eines Rauheitsprofils derart, dass eine Oberflächenrauheit der Rückseite mit einem Mittenrauwert Ra von 0,1 µm bis 0,7 µm, vorzugsweise von 0,1 µm bis 0,5 µm, erzeugt wird. Eine derartige Oberflächenrauheit kann vorteilhaft mittels der Glättungsschicht besonders gut, d.h. vollständig, ausgeglichen werden. Zudem begünstigt die verbliebene Oberflächenrauheit der Rückseite ein Anhaften der Glättungsschicht, insbesondere infolge von Verkrallungseffekten. Das Bearbeiten der Rückseite kann mittels eines, insbesondere kurzzeitigen, Läpp- oder Polierschritts erfolgen.

In weiterer Ausgestaltung der Erfindung wird bei Durchführung des Schritts d) durch die Glättungsschicht eine von der Rückseite abgewandte freie Oberfläche zum Einkoppeln des Laserstrahls ausgebildet, die eine Oberflächenrauheit mit einem Mittenrauwert Ra im Bereich von 0,3 nm bis 30 nm, insbesondere im Bereich von 0,3 nm bis 10 nm, aufweist. Bei einer derartigen Oberflächenrauheit kann der Laserstrahl besonders streuungsarm und somit nahezu verlustfrei in die freie Oberfläche eingekoppelt werden.

In weiterer Ausgestaltung der Erfindung wird die Glättungsschicht gemäß Schritt d) mit einer mittleren Schichtdicke im Bereich von 0,1 µm bis 200 µm, vorzugsweise im Bereich von 0,1 µm bis 2 µm, angebracht. Je dünner die Glättungsschicht ist, desto geringer können etwaige Verluste bei der Führung des Laserstrahls durch das Material der Glättungsschicht sein.

In weiterer Ausgestaltung der Erfindung sind die Glättungsschicht und das Aufwachssubstrat transparent für Laserstrahlung mit einer Wellenlänge aus dem Bereich von 200 nm bis 400 nm, vorzugsweise von 235 nm bis 330 nm. Dabei wird bei Durchführung des Schritts e) der Laserstrahl mit einer derartigen Wellenlänge eingestrahlt. Auf diese Weise lassen sich besonders feine Strukturen der herzustellenden mikroelektronischen Komponente erzeugen.

In weiterer Ausgestaltung der Erfindung liegt ein Verhältnis eines optischen Brechungsindexes des Aufwachssubstrats zu dem optischen Brechungsindex der Glättungsschicht im Bereich von 0,7 bis 1,2, vorzugsweise im Bereich von 0,9 bis 1,1. Dabei weist das Aufwachssubstrat insbesondere einen optischen Brechungsindex im Bereich von 1,7 bis 1,9, insbesondere bei Einstrahlung von Licht mit einer Wellenlänge von 248 nm, auf. Dies hat eine besonders geringe Beeinflussung einer Strahlform des Laserstrahls zur Folge, wenn dieser durch die Glättungsschicht und das Aufwachssubstrat hindurch eingestrahlt wird.

In weiterer Ausgestaltung der Erfindung wird der Schritt d) zeitlich vor Schritt a), insbesondere zu Beginn einer Durchführung des Verfahrens, durchgeführt. Alternativ wird der Schritt d) zeitlich nach dem Schritt a) durchgeführt.

In weiterer Ausgestaltung der Erfindung werden bei Durchführung des Schritts d) das Aufwachssubstrat sowie - alternativ oder zusätzlich - das Rohmaterial und/oder die Folie mit Ultraschall beaufschlagt, insbesondere wobei das Beaufschlagen mit Ultraschall mit dem Schritt d) abgeschlossen wird oder zeitlich über den Schritt d) hinaus erfolgt. Durch die Beaufschlagung mit Ultraschall lässt sich eine Benetzung der Rückseite des Aufwachssubstrats bzw. ein Auffüllen der Höhenunterschiede des Rauheitsprofils der Rückseite mit dem Material der Glättungsschicht verbessern.

Die erfindungsgemäße Aufwachssubstratanordnung dient einer Herstellung mikroelektronischer Komponenten. Die Aufwachssubstratanordnung weist ein Aufwachssubstrat auf. Das Aufwachssubstrat hat eine Vorderseite, auf welcher ein Funktionsschichtsystem bildbar ist. Zudem hat das Aufwachssubstrat eine Rückseite, die der Vorderseite gegenüberliegt. Die Aufwachssubstratanordnung umfasst eine für einen Laserstrahl transparente Glättungsschicht, die an der Rückseite angebracht ist. Die Glättungsschicht liegt in fester Struktur vor. Die Aufwachssubstratanordnung kann im Zuge der Durchführung eines erfindungsgemäßen Verfahrens, insbesondere in Schritt d), hergestellt werden. Insbesondere kann der Schritt d) zeitlich und/oder örtlich separat von den übrigen Schritten ausgeführt werden, beispielsweise um einen Vorrat an Aufwachssubstratanordnungen herzustellen. Die Aufwachssubstratanordnung kann wiederverwendbar sein, sodass mittels ein und derselben Aufwachssubstratanordnung in seriellen Vorgängen mikroelektronische Komponenten nach dem oben beschriebenen Prinzip herstellbar sind. Mithilfe der Aufwachssubstratanordnung kann somit die Effizienz des Verfahrens im Vergleich zum Stand der Technik verbessert werden. Die voranstehende Beschreibung und die zugehörigen Vorteile des erfindungsgemäßen Verfahrens gelten, insbesondere betreffend Merkmale des Aufwachssubstrats und der Glättungsschicht, auch für die erfindungsgemäße Aufwachssubstratanordnung.

In Ausgestaltung der Aufwachssubstratanordnung sind an der Rückseite des Aufwachssubstrats vorhandene Höhenunterschiede eines Rauheitsprofils der Rückseite mit einem Material der Glättungsschicht ausgeglichen. Die Glättungsschicht kann dabei eine von der Rückseite abgewandte freie Oberfläche zum Einkoppeln des Laserstrahls ausbilden, die eine Oberflächenrauheit mit einem Mittenrauwert Ra im Bereich von 0,3 nm bis 30 nm, insbesondere im Bereich von 0,3 nm bis 10 nm, aufweist.

In weiterer Ausgestaltung der Aufwachssubstratanordnung umfasst ein Material der Glättungsschicht ein Polymer, ein Glasmaterial oder eine Folie. Die Glättungsschicht kann eine mittlere Schichtdicke im Bereich von 0,1 µm bis 200 µm, vorzugsweise im Bereich von 0,1 µm bis 2 µm, aufweisen.

Zweckmäßig wird, insbesondere für das Verfahren und/oder für die Aufwachssubstratanordnung, ein kristallines Aufwachssubstrat, insbesondere in Form eines Saphirwafers, verwendet. Alternativ oder zusätzlich kann das Funktionsschichtsystem Halbleiterschichten aus Galliumnitrid (GaN) aufweisen, wobei die Halbleiterschichten auf die Vorderseite des Aufwachssubstrats durch epitaktisches Wachstum gebildet sind.

### KURZBESCHREIBUNG DER ZEICHNUNGEN

Weitere Vorteile und Merkmale ergeben sich aus den Ansprüchen sowie aus der nachfolgenden Beschreibung eines bevorzugten Ausführungsbeispiels der Erfindung, welches anhand der Zeichnungen dargestellt ist. Dabei beziehen sich gleiche Bezugszeichen auf gleiche oder ähnliche oder funktional gleiche Bauteile.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.
- Fig. 1: zeigt schematisch einen Schnitt durch ein Ausführungsbeispiel eines Werkstücks in Form eines Schichtverbunds vor einer Laserbestrahlung;
- Fig. 2: zeigt die Schichten des Werkstücks aus Fig. 1 bei einer späteren Verfahrensstufe nach Auftrennung des Werkstücks in zwei Schichtstapel in einem Laser-Lift-Off-Verfahren;
- Fig. 3: zeigt das Werkstück aus Fig. 1 nach Wenden des Werkstücks beim Aufbringen eines flüssigen Rohmaterials für eine Glättungsschicht des Werkstücks auf die raue Rückseite eines Aufwachssubstrats;
- Fig. 4: zeigt das Werkstück aus Fig. 1 beim Aushärten des Rohmaterials zur festen Glättungsschicht;
- Fig. 5: zeigt das Werkstück aus Fig. 1 nach Erzeugung der Glättungsschicht während einer Laserbearbeitungsoperation;
- Fig. 6: zeigt schematisch einen Schnitt durch ein Ausführungsbeispiel eines Aufwachssubstrats und einer Folie für die Glättungsschicht;
- Fig. 7: zeigt eine Aufwachssubstratanordnung mit dem Aufwachssubstrat aus Fig. 6 und mit fester Glättungsschicht.

### DETAILLIERTE BESCHREIBUNG DER AUSFÜHRUNGSBEISPIELE

Nachfolgend werden anhand von Ausführungsbeispielen verschiedene Aspekte erfindungsgemäßer Verfahren zur Herstellung mikroelektronischer Komponenten unter Verwendung eines Laser-Lift-Off-Verfahrens beschrieben. Die als Produkte des Verfahrens resultierenden mikroelektronischen Komponenten weisen einen in der Regel relativ dünnen flachen Träger 140 und ein auf dem Träger 140 aufgebrachtes mikroelektronisches Funktionsschichtsystem 130 auf.

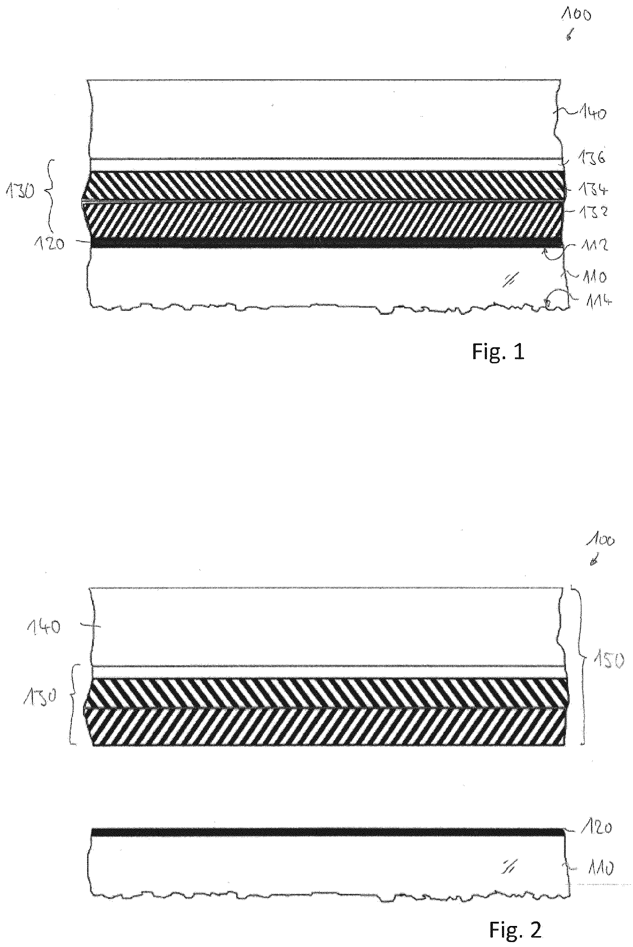

Fig. 1 zeigt einen schematischen Schnitt durch ein Werkstück 100 in Form eines Schichtverbunds mit einem beispielhaften Schichtaufbau. Das Werkstück 100 ist ein im Verlauf des Verfahrens erzeugtes Zwischenprodukt, das unter anderem einer Laserstrahlbearbeitung unterzogen wird. Fig. 2 zeigt eine spätere Verfahrensstufe nach Auftrennung des Werkstücks 100 in zwei Schichtstapel in einem Laser-Lift-Off-Verfahren.

Bei den zu bearbeitenden Werkstücken 100 kann es sich beispielsweise um die eingangs beschriebenen Waferverbünde zur Herstellung von LEDs handeln, jedoch sind auch andere Schichtmaterialien und -abfolgen sowie Wafermaterialien denkbar. Im Folgenden wird der Prozess anhand der LED-Herstellung beschrieben, die Anwendbarkeit der Erfindung beschränkt sich jedoch nicht auf dieses Ausführungsbeispiel.

Das in Fig. 1 gezeigte Werkstück 100 weist ein Aufwachssubstrat 110 in Form eines flachen Saphirwafers auf. Auf die mit hoher Präzision eben bearbeitete Vorderseite 112 des Aufwachssubstrats 110 werden durch epitaktisches Wachstum p-dotierte und n-dotierte Halbleiterschichten 132, 134 aus Galliumnitrid (GaN) gebildet. Im Grenzbereich zum Aufwachssubstrat 110 wird eine dünne Pufferschicht 120 gebildet. Bei der Pufferschicht 120 kann es sich um eine gesonderte Schicht, zum Beispiel aus undotiertem GaN, oder um eine dünne Teilschicht der ersten GaN-Schicht handeln. Die GaN-Schichten haben in der Regel jeweils eine Dicke von wenigen Mikrometern, die Gesamtdicke der verschiedenen GaN-Schichten kann zum Beispiel weniger als 10 µm betragen. Vor der weiteren Bearbeitung kann eine Strukturierung der GaN-Schichten, beispielsweise durch Laserbearbeitung, erfolgen, um einzelne Bauelemente herzustellen oder deren Herstellung vorzubereiten.

Auf den GaN-Schichtstapel wird eine in der Regel wenige Mikrometer dicke Verbindungsschicht 136 aufgebracht, beispielsweise durch Aufdampfen. Diese Verbindungsschicht 136 kann zum Beispiel aus Gold, Platin, Chrom oder anderen Metallen bestehen. Mithilfe dieser Verbindungsschicht 136 wird das Aufwachssubstrat 110 mit dem darauf befindlichen GaN-Schichtstapel mit einem schichtförmigen flachen Träger 140 verbunden. Der Träger 140 wird im Beispielsfall durch eine dünne Scheibe aus Glas gebildet, kann aber auch aus einem anderen Material bestehen, zum Beispiel einem Halbleitermaterial wie zum Beispiel Silizium. Die Verbindungsschicht 136 sowie die angrenzenden GaN-Schichten bilden, gegebenenfalls mit weiteren Schichten, ein Funktionsschichtsystem 130, das wesentlich für die Funktionalität der herzustellenden Komponente verantwortlich ist und in der fertigen Komponente von dem Träger 140 oder einem zugehörigen Abschnitt des Trägers 140 getragen wird. Der Schichtverbund mit dem Träger 140 und dem Funktionsschichtsystem 130 wird hier als Funktions-Schichtstapel 150 bezeichnet.

Die als Aufwachssubstrate 110 verwendeten Saphirwafer werden in der Regel mit einer Säge aus einem größeren Saphir-Block (sapphire ingot) geschnitten. Durch das Sägen entstehen Oberflächen hoher Rauigkeit. Die Rückseite 114 eines Aufwachssubstrats 110 aus Saphir kann zum Beispiel eine mittlere Oberflächenrauigkeit Ra bis etwa 2 µm und eine gemittelte Rautiefe Rz bis etwa 20 µm aufweisen. Wird eine solche Oberfläche mit einem Laser bestrahlt, geht ein deutlicher Prozentsatz der eingestrahlten Laserleistung durch Streuung an der rauen Oberfläche verloren und steht nicht mehr für den eigentlichen Lift-Off-Prozess zur Verfügung. Außerdem verschlechtert sich die Strahlqualität - insbesondere die Strahlhomogenität - dadurch merklich, was zu Problemen beim Lift-Off-Prozess führen kann.

Um dies zu verhindern, kann die Rückseite 114 des Aufwachssubstrats 110 durch Polieren geglättet werden. Dies bedeutet allerdings, dass bei der Produktion der Bauelemente ein oder sogar mehrere zusätzliche Bearbeitungsschritte durchgeführt werden müssen, wodurch sich wiederum die Bauelemente verteuern.

In einem Ausführungsbeispiel wird die Rückseite 114 zur Erzeugung eines Rauheitsprofils 115 derart bearbeitet, dass eine Oberflächenrauigkeit der Rückseite 114 mit einem Mittenrauwert Ra von 0,1 µm bis 0,7 µm, vorzugsweise von 0,1 µm bis 0,5 µm, erzeugt wird. Beispielsweise kann die Oberflächenrauigkeit auf einen derartigen Mittenrauwert durch die Bearbeitung der Oberfläche reduziert werden. Bei einer solchen Rauigkeit wird der eingestrahlte Laserstrahl beim Lift-Off-Prozess allerdings noch stark gestreut.

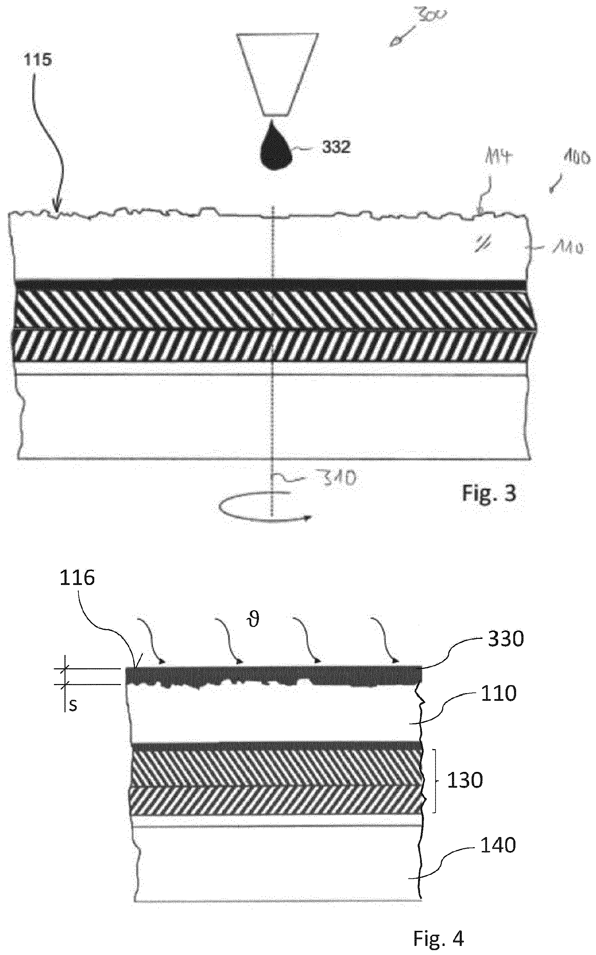

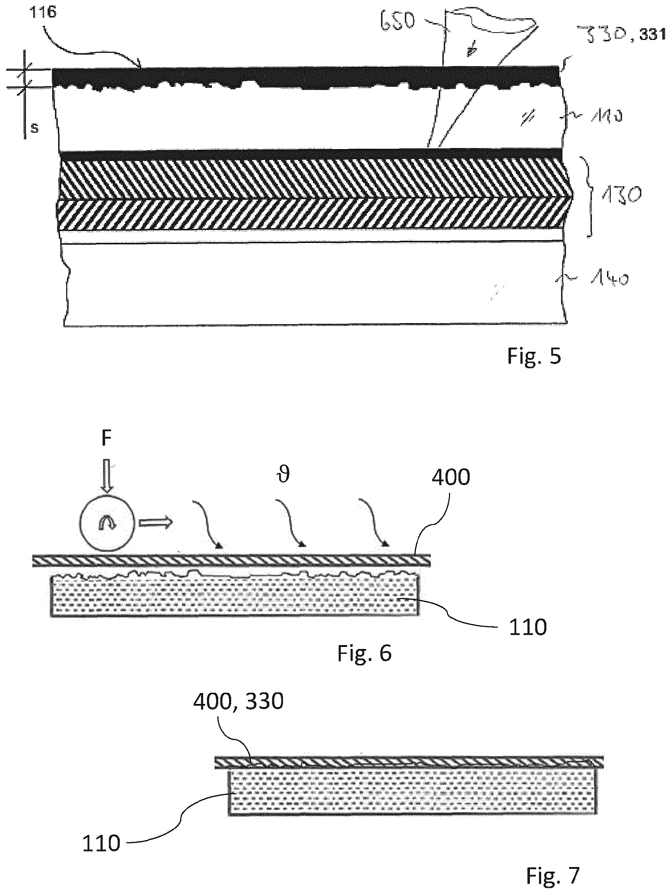

Gemäß dem Verfahren wird daher auf der Rückseite 114 des Aufwachssubstrats 110 eine für einen Laserstrahl 650 transparente Glättungsschicht 330 erzeugt. Bevor der Laserstrahl 650 eingestrahlt wird, liegt die Glättungsschicht 330 mit fester Struktur vor. Die raue Rückseite 114 des Aufwachssubstrats 110 wird also mit der Glättungsschicht 330 beschichtet (Fig. 3), um bei der nachfolgenden Laserbearbeitung (Fig. 5) die Streuung der Laserstrahlung an der rauen Oberfläche der Rückseite 114 zu verhindern oder auf ein unkritisches Maß zu reduzieren.

Das Aufwachssubstrat 110 und die darauf haftende feste Glättungsschicht 330 bilden eine Ausführungsform einer erfindungsgemäßen Aufwachssubstratanordnung aus. Die Aufwachssubstratanordnung kann für mehrere aufeinanderfolgende Durchführungen des Laser-Lift-Off-Verfahrens wiederverwendet werden.

Beispielsweise wird das Werkstück 100 nach einer Wende-Operation mit der rauen Rückseite 114 des Aufwachssubstrats 110 nach oben auf einer Spin-Coating-Einrichtung 300 platziert und in Umdrehung um die senkrechte Achse 310 versetzt. Die Drehzahl kann dabei bis zu 5.000 U/min betragen. Gleichzeitig wird aus einer Düse ein flüssiges Rohmaterial 332 für die Glättungsschicht 330 auf die raue Rückseite 114 des Aufwachssubstrats 110 aufgebracht, so dass sich das flüssige Rohmaterial 332 durch die Rotation über die gesamte Oberfläche der Rückseite 114 gleichmäßig verteilt. Die Benetzung der Rückseite 114 wird dabei so geführt, dass die Dicke der noch flüssigen Glättungsschicht 330 (vgl. Fig. 4) mindestens so groß wird, dass alle Vertiefungen der Oberflächenrauheit aufgefüllt sind. Die Schichtdicke kann aber auch größer sein. Im Beispiel von Fig. 4 beträgt die Schichtdicke der noch flüssigen Glättungsschicht 330 zum Beispiel 2 µm.

Nachdem das flüssige Rohmaterial 332 mit der Rückseite 114 des Aufwachssubstrats 110 in Kontakt gebracht wurde, wird das Rohmaterial 332 unter Ausbildung der Glättungsschicht 330 ausgehärtet. Beim Erzeugen der Glättungsschicht 330 werden an der Rückseite 114 des Aufwachssubstrats 110 vorhandene Höhenunterschiede des Rauheitsprofils 115 mit einem Material 331 der Glättungsschicht 330 ausgeglichen. Beim Aushärten kann das flüssige Rohmaterial 332 zum festen Material 331 der festen Glättungsschicht 330 umgebildet werden.

Das flüssige Rohmaterial 332 weist vorliegend eine Viskosität von 1 mPas bis 3.000 mPas auf. Beispielsweise kann die Viskosität des flüssigen Rohmaterials 332 3 mPas bis 300 mPas betragen. Das flüssige Rohmaterial 332 weist beispielsweise wenigstens ein vernetzungsfähiges Polymer auf. Dabei erfolgt das Aushärten zur Glättungsschicht 330 durch Vernetzen des Polymers. Zum Starten einer Vernetzungsreaktion des Polymers kann dem flüssigen Rohmaterial 332 Energie zugeführt werden. Vor diesem Hintergrund wird dem Rohmaterial 332 wie beispielsweise in Fig. 4 gezeigt Wärme ϑ zugeführt.

Es ist auch denkbar, dass das Rohmaterial 332 zum Aushärten mit Laserstrahlung oder Plasma beaufschlagt oder mit UV-Licht bestrahlt wird. Zumindest letzteres bietet sich insbesondere dann an, wenn das Polymer als Bestandteil eines Photoresists, d. h. eines Photolacks, vorliegt.

Die Glättungsschicht 330 bildet eine von der Rückseite 114 abgewandte freie Oberfläche 116 zum Einkoppeln des Laserstrahls 650 aus. Eine Oberflächenrauigkeit dieser freien Oberfläche hat beispielsweise einen Mittenrauwert Ra im Bereich von 0,3 nm bis 30 nm, vorliegend im Bereich von 0,3 nm bis 10 nm. Die Glättungsschicht 330 weist beispielsweise eine mittlere Schichtdicke s im Bereich von 0,1 µm bis 200 µm, vorliegend im Bereich von 0,1 µm bis 2 µm, auf. Sowohl die Glättungsschicht 330 als auch das Aufwachssubstrat 110 sind transparent für Laserstrahlung mit einer Wellenlänge aus dem Bereich von 200 nm bis 400 nm. Beispielsweise sind die Glättungsschicht 330 und das Aufwachssubstrat 110 transparent für Laserstrahlung mit einer Wellenlänge aus dem Bereich von 235 nm bis 330 nm. Mit einer solchen Wellenlänge wird der Laserstrahl 650 bei der Laserbearbeitung eingestrahlt.

Um eine Brechung des Laserstrahls 650 beim Übertritt von der Glättungsschicht 330 in das Aufwachssubstrat 110 möglichst gering zu halten, sollten optische Brechungsindizes der Glättungsschicht 330 und des Aufwachssubstrats 110 eine möglichst geringe Abweichung voneinander haben. Idealerweise haben das Aufwachssubstrat 110 und die Glättungsschicht 330 den gleichen Brechungsindex. Das Aufwachssubstrat 110 in Form des Saphirwafers weist vorliegend bei einer Wellenlänge von 248 nm einen optischen Brechungsindex von 1,827 auf. Ein Verhältnis des optischen Brechungsindexes des Aufwachssubstrats 110 zu dem optischen Brechungsindex der Glättungsschicht 330 liegt vorliegend im Bereich von 0,9 bis 1,1.

Beispielsweise wird die Glättungsschicht 330 an der Rückseite 114 des Aufwachssubstrats 110 erzeugt, bevor das Funktionsschichtsystem 130 auf der Vorderseite 112 des Aufwachssubstrats 110 gebildet wird. Mit anderen Worten: Das Aufwachssubstrat 110 kann zunächst an seiner Rückseite 114 mit der Glättungsschicht 330 versehen werden, bevor das Funktionsschichtsystem 130 auf der Vorderseite 112 ausgebildet wird. Die Glättungsschicht 330 ist erst erzeugt, wenn ein Material 331 der Glättungsschicht 330 mit fester Struktur, d.h. beispielsweise als Festkörper, vorliegt. Alternativ kann zunächst das Funktionsschichtsystem 130 auf der Vorderseite 112 des Aufwachssubstrats 110 gebildet werden, bevor die Glättungsschicht 330 an der Rückseite 114 des Aufwachssubstrats 110 erzeugt wird.

Bei der Erzeugung der Glättungsschicht 330 werden beispielsweise das Aufwachssubstrat 110 sowie - alternativ oder zusätzlich - das Rohmaterial 332 mit Ultraschall beaufschlagt. Beispielsweise kann das Beaufschlagen mit Ultraschall abgeschlossen werden, wenn die Glättungsschicht 330 mit fester Struktur vorliegt oder zeitlich darüber hinaus erfolgen.

Bei der Laserbearbeitungsoperation wird das Werkstück 100 mit einem Laserstrahl 650 bestrahlt. Der Laserstrahl 650 kann von einem Excimerlaser erzeugt werden. Der Laserstrahl 650 weist vorliegend eine Wellenlänge von 248 nm auf. Andere Wellenlängen, beispielsweise 308 nm oder 351 nm, sind jedoch ebenfalls möglich. Wellenlängen im sichtbaren und nahen Infrarotbereich sind ebenfalls möglich. Auch die Verwendung eines anderen Lasertyps wie zum Beispiel eines diodengepumpten Festkörperlasers ist möglich. Die Wellenlänge muss jedoch so gewählt sein, dass sowohl das Aufwachssubstrat 110 als auch die Glättungsschicht 330 bei dieser Wellenlänge vollständig oder weitgehend transparent sind. Dadurch durchdringt der Laserstrahl 650 die Glättungsschicht 330 und das Aufwachssubstrat 110 ohne Wechselwirkung oder nur mit einer geringen Wechselwirkung und wird erst in der Pufferschicht 120 bzw. im Grenzbereich zwischen Aufwachssubstrat 110 und GaN-Funktionsschichten absorbiert (vgl. Fig. 5).

Der auf die Pufferschicht 120 treffende Laserstrahl 650 hat ein langgezogenes, linienförmiges Profil. Im Idealfall ist die lange Achse des Strahlprofils so lang, dass dieses über den gesamten Durchmesser des Werkstücks reicht. Beispielsweise kann für einen Saphirwafer mit einem Durchmesser von 6" (152,4 mm) ein Strahlprofil mit einer Länge von 155 mm oder mehr und einer Breite im Bereich von 0,2 mm bis 0,5 mm (zum Beispiel etwa 0,33 mm) verwendet werden. Die Energiedichte im Fokusbereich kann unter diesen Bedingungen im Bereich von etwa 1.100 bis 1.700 mJ/cm² liegen, was ausreichend für die Schwächung oder Zerstörung der Verbindung im Grenzbereich ist.

Während des Fortschreitens der Laserbearbeitung wird die Fokusposition der Laserlinie durch Verschieben der Fokussierlinie oder des Werkstücks 100 so korrigiert, dass die zu bestrahlende Pufferschicht 120 innerhalb des Schichtstapels über die gesamte Laserlinie innerhalb des Schärfentiefe-Bereichs des Lasers liegt. Zwar wird durch die Laserbestrahlung die Pufferschicht 120 zerstört, jedoch haften das Aufwachssubstrat 110 und die GaN-Schichten durch Adhäsionskräfte weiter aneinander, so dass die endgültige Trennung durch die Einwirkung einer externen Kraft erfolgen muss. Infolge einer derartigen externen Kraft kann das Aufwachssubstrat 110 endgültig von dem Funktions-Schichtstapel 150 (Schichtverbund mit Träger 140 und Funktionsschichtsystem 130) getrennt werden.

Mithilfe des Verfahrens können zum Beispiel Leuchtdioden bzw. lichtemittierende Dioden in hoher Qualität kostengünstig hergestellt werden. Bei Nutzung anderer Funktionsschichtsysteme 130 und gegebenenfalls anderer Materialien für den Träger 140 und/oder das Aufwachssubstrat 110 können auch andere Komponenten, zum Beispiel Displays, hergestellt werden.

Bei dem Polymer des flüssigen Rohmaterials 332 kann es sich beispielsweise um PMMA handeln. Alternativ kann es sich bei dem Polymer um ein Polysilazan oder um ein Silikon handeln.

Bei Verwendung von Polysilazan für die Glättungsschicht 330 kann eine Pyrolyse des an der Rückseite des Aufwachssubstrats angebrachten Polysilazans erfolgen. Infolge der Pyrolyse des Polysilazans kann ein keramisches Material 331 der Glättungsschicht 330 erzeugt werden. Zeitlich vor der Pyrolyse kann eine Trocknung erfolgen.

Das flüssige Rohmaterial 332 kann bei einer alternativen Ausführungsform des Verfahrens eine Suspension oder eine kolloidale Dispersion mit wenigstens einem Glas-Rohstoff. Der Glas-Rohstoff kann SiOz aufweisen. Dabei wird das flüssige Rohmaterial 332 bei dieser Ausführungsform des Verfahrens nach seinem Auftrag auf der Rückseite 114 zunächst getrocknet. Es folgt eine thermische Behandlung, um aus dem Glas-Rohstoff ein Glasmaterial der Glättungsschicht 330 zu erzeugen. Die Erzeugung des Glasmaterials aus dem Glas-Rohstoff kann mittels eines Sol-Gel-Prozesses erfolgen.

Die Glättungsschicht 330 kann bei Durchführung des Schritts d) mehrlagig erzeugt werden. "Mehrlagig" kann dabei bedeuten, dass die Glättungsschicht 330 in der Art eines Glättungsschichtstapels mit mehreren Schichtlagen erzeugt wird, z.B. mit genau zwei, genau drei, genau vier oder mehr Schichtlagen. Die Glättungsschicht 330 kann somit zum Ende des Schritts d) mehrlagig vorliegen. Die Schichtlagen können sich in ihrem Material sowie in ihrer Herstellung unterscheiden. Die mehreren Schichtlagen können die vorstehend erläuterten und die nachstehend noch zu erläuternden Materialen und Herstellungsprozesse in der mehrlagigen Glättungsschicht 330 miteinander kombinieren. Sofern aushärtbare Materialien verwendet werden, können die entsprechenden Materialien 331 der Schichtlagen zeitgleich oder zeitlich nacheinander ausgehärtet werden.

Die Fig. 6 und 7 illustrieren eine weitere Ausführungsform des Verfahrens. Dabei ist die Herstellung einer erfindungsgemäßen Aufwachssubstratanordnung gezeigt, die in Folge des Schritts d) hergestellt wird. Die Aufwachssubstratanordnung umfasst das Aufwachssubstrat 110 und die Glättungsschicht 330. Bei der Ausführungsform nach den Fig. 6 und 7 umfasst die Glättungsschicht 330 eine Folie 400. Die Folie 400 wird zum Erzeugen der Glättungsschicht 330 auf der Rückseite 114 des Aufwachssubstrats 110 befestigt. Die Folie 400 wird vorliegend auf die Rückseite 114 des Aufwachssubstrats 110 aufgewalzt. Das Aufwalzen erfolgt dabei derart, dass die Folie 400 in an der Rückseite 114 des Aufwachssubstrats 110 vorhandene Vertiefungen des Rauheitsprofils 115 gedrückt wird. Beim Anbringen der Folie 400 an der Rückseite 114 kann die Folie 400 mit Wärme ϑ beaufschlagt werden. Die Folie 400 kann ein thermoplastisches Material aufweisen, das infolge der Erwärmung plastisch verformbar wird und somit in die Vertiefungen des Rauheitsprofils 115 hineingedrückt werden kann.

Bei einer Variante des Verfahrens ist die Folie 400 mit Klebstoff beschichtet. Dabei wird die Folie 400 mittels des Klebstoffs an der Rückseite 114 befestigt. Der Klebstoff kann in die Vertiefungen des Rauheitsprofils eindringen, um die Höhenunterschiede auszugleichen. Das Aufwachssubstrat 110 sowie - alternativ oder zusätzlich - die Folie 400 können zur Erzeugung der Glättungsschicht 330 mit Ultraschall beaufschlagt werden.

Eine einlagige Folie 400 kann unmittelbar auf dem Aufwachssubstrat haften und dadurch eine einlagige Glättungsschicht 330 ausbilden. Alternativ kann die Folie 400 oder die mit Klebstoff beschichtete Folie auf einer bereits an der Rückseite 114 des Aufwachssubstrats 110 angebrachten, d. h. weiteren, Schichtlage der Glättungsschicht 330 angebracht werden. Dadurch sind mehrlagige Glättungsschichten mit zwei oder drei oder mehr übereinanderliegenden Schichtlagen ggf. unterschiedlicher Materialien herstellbar. Sofern das das Material 331 der weiteren Schichtlage aushärtbar ist, kann das Material vor oder nach dem Anbringen der Folie 400 oder der mit Klebstoff beschichteten Folie ausgehärtet werden.

Wenn das Material 331 nach dem Aufwalzen der Folie 400 ausgehärtet und die Folie 400 anschließend wieder entfernt wird, kann eine besonders dünnschichtige Glättungsschicht 330 erzeugt werden, die nur wenig oder gar nicht über lokale Maxima des Rauheitsprofils hinausreicht. Es versteht sich, dass die Folie 400 in diesem Fall kein Bestandteil der Glättungsschicht 330 ist.

Bei einer weiteren Ausführungsform des Verfahrens wird die Glättungsschicht 330 an der Rückseite 114 des Aufwachssubstrats 110 durch Sputtern erzeugt. Als Material 331 der Glättungsschicht 330 wird beispielsweise Aluminiumoxid verwendet. Das Sputtern kann so erfolgen, dass eine Dicke der Glättungsschicht 330 um 1 nm/s zunimmt.

## Patentansprüche

1. Verfahren zur Herstellung mikroelektronischer Komponenten, die einen Träger (140) und ein auf dem Träger (140) aufgebrachtes mikroelektronisches Funktionsschichtsystem (130) aufweisen, mit folgenden Schritten:
a) Bilden eines Funktionsschichtsystems (130) auf einer Vorderseite (112) eines Aufwachssubstrats (110);
b) Aufbringen eines schichtförmigen Trägers (140) auf das Funktionsschichtsystem (130) zur Bildung eines Werkstücks (100) in Form eines Schichtverbundes, der den Träger (140), das Funktionsschichtsystem (130) und das Aufwachssubstrat (110) aufweist;
c) Befestigen des Werkstücks (100) auf einem Werkstückträger derart, dass eine der Vorderseite (112) gegenüberliegende Rückseite (114) des Aufwachssubstrats (110) zugänglich ist;
d) Erzeugen einer für einen Laserstrahl (650) transparenten Glättungsschicht (330) an der Rückseite (114) des Aufwachssubstrats (110);
e) Einstrahlen des Laserstrahls (650) von der Rückseite (114) des Aufwachssubstrats (110) durch die Glättungsschicht (330) und durch das Aufwachssubstrat (110) hindurch derart, dass der Laserstrahl (650) in einem Grenzbereich zwischen dem Aufwachssubstrat (110) und dem Funktionsschichtsystem (130) fokussiert wird und eine Verbindung zwischen dem Aufwachssubstrat (110) und dem Funktionsschichtsystem (130) im Grenzbereich geschwächt oder zerstört wird;
f) Trennen eines den Träger (140) und das Funktionsschichtsystem (130) aufweisenden Funktions-Schichtstapels (150) von dem Aufwachssubstrat (110);
**dadurch gekennzeichnet, dass**
die Glättungsschicht (330) derart erzeugt wird, dass zum Ende des Schritts d) die Glättungsschicht (330) mit fester Struktur vorliegt.

2. Verfahren nach Anspruch 1, **dadurch gekennzeichnet, dass** beim Erzeugen der Glättungsschicht (330) gemäß Schritt d) an der Rückseite (114) des Aufwachssubstrats (110) vorhandene Höhenunterschiede eines Rauheitsprofils (115) mit einem Material (331) der Glättungsschicht (330) ausgeglichen werden.

3. Verfahren nach Anspruch 1 oder 2, **dadurch gekennzeichnet, dass** zum Erzeugen der Glättungsschicht (330) gemäß Schritt d) ein flüssiges Rohmaterial (332) für die Glättungsschicht (330) mit der Rückseite (114) des Aufwachssubstrats (110) in Kontakt gebracht und anschließend unter Ausbildung der Glättungsschicht (330) ausgehärtet wird, wobei bevorzugt wenigstens eine der nachfolgenden Bedingungen erfüllt ist:
- das flüssige Rohmaterial (332) weist eine Viskosität von 1 mPas bis 3000 mPas, insbesondere von 3 mPas bis 300 mPas, auf,
- das flüssige Rohmaterial (332) weist wenigstens ein vernetzungsfähiges Polymer auf und das Aushärten zur Glättungsschicht (330) umfasst ein Vernetzen des Polymers,
- das flüssige Rohmaterial (332) umfasst eine Suspension oder eine kolloidale Dispersion mit wenigstens einem Glas-Rohstoff, wobei das flüssige Rohmaterial (332) zum Aushärten zunächst getrocknet und anschließend thermisch behandelt wird, um aus dem Glas-Rohstoff ein Glasmaterial der Glättungsschicht (330) zu erzeugen.

4. Verfahren nach einem der vorhergehenden Ansprüche, **dadurch gekennzeichnet, dass** bei Durchführung des Schritts d) die Glättungsschicht (330) mit wenigstens zwei Schichtlagen mehrlagig erzeugt wird.

5. Verfahren nach einem der vorhergehenden Ansprüche, **dadurch gekennzeichnet, dass** die Glättungsschicht (330) eine Folie (400) oder eine mit Klebstoff beschichtete Folie umfasst, wobei die Folie zum Erzeugen der Glättungsschicht (330) gemäß Schritt d) auf der Rückseite (114) des Aufwachssubstrats (110) derart befestigt wird, dass an der Rückseite (114) des Aufwachssubstrats (110) vorhandene Höhenunterschiede eines Rauheitsprofils (115) von der Folie und/oder dem Klebstoff ausgeglichen werden, wobei bevorzugt wenigstens eine der nachfolgenden Bedingungen erfüllt wird:
- die Folie (400) oder die mit Klebstoff beschichtete Folie wird auf einer bereits an der Rückseite (114) des Aufwachssubstrats (110) angebrachten Schichtlage der Glättungsschicht (330) angebracht,
- die Folie (400) wird auf die Rückseite (114) des Aufwachssubstrats (110) aufgedrückt, insbesondere aufgewalzt, so dass die Folie (400) und/oder der zwischen Folie (400) und Rückseite (114) angeordnete Klebstoff und/oder eine bereits an der Rückseite (114) des Aufwachssubstrats (110) angebrachten Schichtlage der Glättungsschicht (330) in an der Rückseite (114) des Aufwachssubstrats (110) vorhandene Vertiefungen des Rauheitsprofils (115) gedrückt wird.

6. Verfahren nach einem der vorhergehenden Ansprüche, **dadurch gekennzeichnet, dass** ein an der Rückseite (114) des Aufwachssubstrats (110), insbesondere als Schichtlage, angebrachtes Rohmaterial (332) der Glättungsschicht (330) mittels einer Folie (400) in an der Rückseite (114) des Aufwachssubstrats (110) vorhandene Vertiefungen des Rauheitsprofils (115) gedrückt und anschließend ausgehärtet wird, wobei die Folie (400) nach dem Aushärten wieder entfernt wird.

7. Verfahren nach Anspruch 1 oder 2, **dadurch gekennzeichnet, dass** zum Erzeugen der Glättungsschicht (330) gemäß Schritt d) ein Rohmaterial (332) auf die Rückseite (114) des Aufwachssubstrats (110) aufgedampft wird, wobei Rohmaterial (332) im Anschluss an das Aufdampfen unter Ausbildung der Glättungsschicht (330) erstarrt; und/oder dass bei Durchführung des Schritts d) die Glättungsschicht (330) oder eine Schichtlage der Glättungsschicht an der Rückseite (114) des Aufwachssubstrats (110) durch Sputtern erzeugt wird, wobei insbesondere Aluminiumoxid als Material (331) der Glättungsschicht (330) verwendet wird.

8. Verfahren nach einem der vorhergehenden Ansprüche, **dadurch gekennzeichnet, dass** das Verfahren folgenden zusätzlichen Schritt umfasst, der vorzugsweise zeitlich nach Schritt e) durchgeführt wird:
g) Entfernen der Glättungsschicht (330) von dem Aufwachssubstrat (110);
und/oder dass das Verfahren folgenden zusätzlichen Schritt umfasst, der zeitlich vor Schritt d) durchgeführt wird:
c*) Bearbeiten der Rückseite (114) zur Erzeugung eines Rauheitsprofils (115) derart, dass eine Oberflächenrauheit der Rückseite (114) mit einem Mittenrauwert Ra von 0,1 µm bis 0,7 µm, vorzugsweise von 0,1 µm bis 0,5 µm, erzeugt wird.

9. Verfahren nach einem der vorhergehenden Ansprüche, **dadurch gekennzeichnet, dass** bei Durchführung des Schritts d) durch die Glättungsschicht (330) eine von der Rückseite (114) abgewandte freie Oberfläche (116) zum Einkoppeln des Laserstrahls (650) ausgebildet wird, die eine Oberflächenrauheit mit einem Mittenrauwert Ra im Bereich von 0,3 nm bis 30 nm, insbesondere im Bereich von 0,3 nm bis 10 nm, aufweist; und/oder dass die Glättungsschicht (330) gemäß Schritt d) mit einer mittleren Schichtdicke (s) im Bereich von 0,1 µm bis 200 µm, vorzugsweise im Bereich von 0,1 µm bis 2 µm, angebracht wird.

10. Verfahren nach einem der vorhergehenden Ansprüche, **dadurch gekennzeichnet, dass** die Glättungsschicht (330) und das Aufwachssubstrat (114) transparent sind für Laserstrahlung (650) mit einer Wellenlänge aus dem Bereich von 200 nm bis 400 nm, vorzugsweise von 235 nm bis 330 nm, wobei bei Durchführung des Schritts e) der Laserstrahl (650) mit einer solche Wellenlänge eingestrahlt wird; und/oder dass ein Verhältnis eines optischen Brechungsindexes des Aufwachssubstrats (110) zu dem optischen Brechungsindex der Glättungsschicht (330) im Bereich von 0,7 bis 1,2, vorzugsweise im Bereich von 0,9 bis 1,1, liegt, wobei das Aufwachssubstrat (110) vorzugsweise einen optischen Brechungsindex im Bereich von 1,7 bis 1,9 aufweist.

11. Verfahren nach einem der vorhergehenden Ansprüche, **dadurch gekennzeichnet, dass**
der Schritt d) zeitlich vor Schritt a), insbesondere zu Beginn einer Durchführung des Verfahrens, durchgeführt wird, oder dass
der Schritt d) zeitlich nach dem Schritt a) durchgeführt wird.

12. Verfahren nach einem der vorhergehenden Ansprüche, **dadurch gekennzeichnet, dass**
bei Durchführung des Schritts d) das Aufwachssubstrat (110) und/oder das Rohmaterial (332) und/oder die Folie (400) mit Ultraschall beaufschlagt werden, insbesondere wobei das Beaufschlagen mit Ultraschall mit dem Schritt d) abgeschlossen wird oder zeitlich über den Schritt d) hinaus erfolgt.

13. Aufwachssubstratanordnung für eine Herstellung mikroelektronischer Komponenten, aufweisend
ein Aufwachssubstrat (110) mit einer Vorderseite (112), auf welcher ein Funktionsschichtsystem (130) bildbar ist und mit einer der Vorderseite (112) gegenüberliegenden Rückseite (114),
eine für einen Laserstrahl (650) transparente Glättungsschicht (330), die an der Rückseite (114) angebracht ist,
**dadurch gekennzeichnet, dass**
die Glättungsschicht (330) eine feste Struktur aufweist.

14. Aufwachssubstratanordnung nach Anspruch 13, **dadurch gekennzeichnet, dass** an der Rückseite (114) des Aufwachssubstrats (110) vorhandene Höhenunterschiede eines Rauheitsprofils (115) mit einem Material (331) der Glättungsschicht (330) ausgeglichen sind, insbesondere derart, dass die Glättungsschicht (330) eine von der Rückseite (114) abgewandte freie Oberfläche (116) zum Einkoppeln des Laserstrahls (650) ausbildet, die eine Oberflächenrauheit mit einem Mittenrauwert Ra im Bereich von 0,3 nm bis 30 nm, insbesondere im Bereich von 0,3 nm bis 10 nm, aufweist; und/oder dass das Material (331) der Glättungsschicht (330) ein Polymer, ein Glasmaterial und/oder eine Folie umfasst, wobei die Glättungsschicht (330) insbesondere eine mittlere Schichtdicke (s) im Bereich von 0,1 µm bis 200 µm, vorzugsweise im Bereich von 0,1 µm bis 2 µm, aufweist.

15. Verfahren nach einem der Ansprüche 1 bis 12, **dadurch gekennzeichnet, dass**
ein kristallines Aufwachssubstrat (110) verwendet wird, insbesondere in Form eines Saphirwafers, und/oder dass das Funktionsschichtsystem (130) Halbleiterschichten (132, 134) aus Galliumnitrid (GaN) aufweist, die auf die Vorderseite (112) des Aufwachssubstrats (110) durch epitaktisches Wachstum gebildet sind.
